# EUROPEAN PATENT APPLICATION

(11) **EP 4 718 271 A1**
(43) Date of publication of application: **01.04.2026**
(21) Application number: 25202537.4
(22) Date of filing: 16.09.2025
(51) Int. Cl.: G06F 13/40, G06F 15/17, G06N 3/063

(54) **SHARED COMMUNICATIONS RESOURCE IN A MULTI-TILE IN-MEMORY COMPUTATION (IMC) NEURAL PROCESSING UNIT (NPU)**

(30) Priority: 26.09.2024 US 202463699241 P; 12.09.2025 US 202519327295
(71) Applicant: STMicroelectronics International N.V., 1228 Plan-les-Ouates, Geneva (CH)
(72) Inventor: CHAWLA, Nitin, 201304 NOIDA (IN); CHELANI, Vikas, 201301 NOIDA (IN); RAWAT, Harsh, 121006 Faridabad (IN); AYODHYAWASI, Manuj, 201304 INDIA (IN)
(74) Representative: Casalonga

(57) **Abstract**

A first in-memory computation (IMC) circuit includes a first IMC processing tile coupled for data communication to a first interface circuit. A second IMC circuit includes a second IMC processing tile coupled for data communication to a second interface circuit. A shared resource bus connects the first and second interface circuits. The first and second interface circuits are controlled by mode control signals to operate in: a first communications mode where signal lines of the shared resource bus support data communications between the first and second IMC circuits; and a second communications mode where a first subset of signal lines of the shared resource bus support data communications between the first and second IMC circuits and a second, different, subset of signal lines of the shared resource bus are driven to a fixed voltage level to provide shielding for the data communications over the first subset of signal lines.

## Description

### CROSS REFERENCE TO RELATED APPLICATIONS

This application claims priority to United States Provisional Application for Patent No. 63/699,241, filed September 26, 2024, the content of which is incorporated herein by reference.

### TECHNICAL FIELD

Embodiments herein relate to a neural processing unit (NPU) utilizing multiple interconnected in-memory computation (IMC) processing tiles.

### BACKGROUND

Data communication between in-memory computation (IMC) tiles is a critical concern within a neural processing unit (NPU). The data passed between IMC tiles can include feature data, weight data and computation data. Significant routing resources are needed in support of high bandwidth operations.

There is a need in the art for a more efficient data communications interconnection between IMC processing tiles.

### SUMMARY

In an embodiment, a circuit comprises: a first in-memory computation (IMC) circuit comprising a first IMC processing tile coupled for data communication to a first interface circuit; a second IMC circuit comprising a second IMC processing tile coupled for data communication to a second interface circuit; a shared resource bus connecting the first interface circuit to the second interface circuit; wherein the first and second interface circuits are controlled by mode control signals to operate in: a first communications mode where signal lines of the shared resource bus support data communications between the first and second IMC circuits; and a second communications mode where a first subset of signal lines of the shared resource bus support data communications between the first and second IMC circuits and a second subset of signal lines of the shared resource bus, different from the first subset, are driven to a fixed voltage level to provide shielding for the data communications over the first subset of signal lines.

The shared resource bus is used by the first and second IMC circuits, in either the first communications mode or the second communications mode, in support of data communications comprising one or more of: feature data for in-memory computation operations performed by one or more of the first and second IMC processing tiles; weight data for in-memory computation operations performed by one or more of the first and second IMC processing tiles, and/or processing data generated by execution of an in-memory computation operation by one of the first and second IMC processing tiles.

In an embodiment, a circuit comprises: a first in-memory computation (IMC) tile coupled to a first data communication interface circuit; a second IMC tile coupled to a second data communication interface circuit; a shared resource bus connecting the first data communication interface circuit to the second data communication interface circuit; wherein a data communication mode implemented by the first and second interface circuits for data communication between the first and second IMC tiles is controlled by a mode control signal such that: when the mode control signal indicates operation in a first data communications mode, all signal lines of the shared resource bus support data communications between the first and second IMC tiles; and when the mode control signal indicates operation in a second data communications mode, a first subset of signal lines of the shared resource bus support data communications between the first and second IMC tiles and a second subset of signal lines of the shared resource bus, different from the first subset, provide shielding for the data communications over the first subset of signal lines.

### BRIEF DESCRIPTION OF THE DRAWINGS

For a better understanding of the embodiments, reference will now be made by way of example only to the accompanying figures in which:
Figure 1A is a block diagram of a multi-island in-memory computation (IMC) neural processing unit (NPU);
Figure 1B is a block diagram for an individual IMC NPU island including a plurality of IMC tile clusters;
Figure 1C is a block diagram of an IMC tile cluster including a plurality of IMC circuits;
Figure 1D is a block diagram of an embodiment for the IMC circuit;
Figure 2A-2B show examples for two modes of operation supporting data communication between IMC processing tiles;
Figures 3A-3C illustrate neural network graph schedules where an IMC tile cluster makes use of both analog and digital IMC processing tile resources; and
Figure 4 shows a tile cluster configuration supporting IMC tiles with decompressor logic and shared compute logic.

### DETAILED DESCRIPTION OF THE DRAWINGS

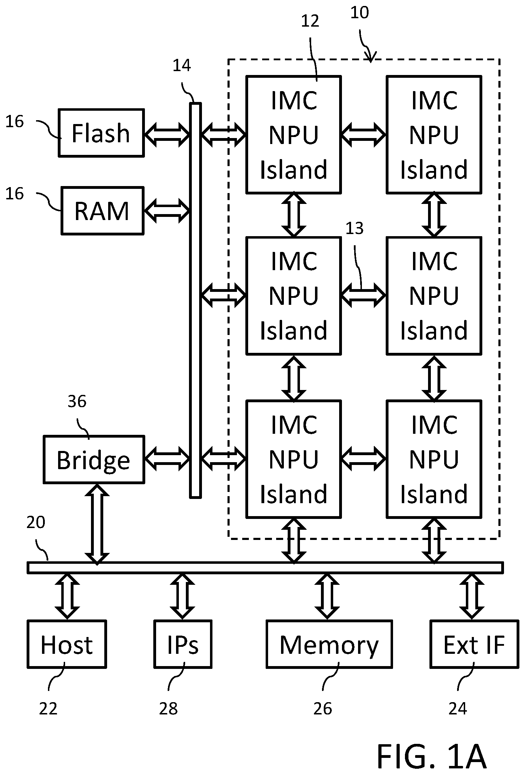

Reference is now made to Figure 1A which shows a processing system block diagram where the system includes a multi-island in-memory computation (IMC) neural processing unit (NPU) 10. The multi-island IMC NPU 10 includes a plurality of IMC NPU islands 12 arranged in an array and interconnected with each other by a data interconnection network 13. The plurality of IMC NPU islands 12 of the multi-island IMC NPU 10 are further connected through a memory bus 14 to memory circuits 16 (comprising, for example, a flash memory, or a random access memory (RAM)). The data stored in the memory circuits 16 include the computational weights of a network. Before the in-memory computation is executed, the weights of a processing layer whose computation is going to be performed are transferred from memory to an IMC tile (to be discussed in detail below) within a given IMC NPU island 12. The system RAM can also store the sum and partial sum, partial product and/or partial compute outputs produced at the outputs of the IMC tiles of the IMC NPU islands 12 which are going to be used in next processing layer computations. The plurality of IMC NPU islands 12 are further coupled through a system bus 20 to a host processing unit 22 and an external interface (IF) circuit 24. The host processing unit 22 (also referred to as the central processing unit (CPU)) is responsible for executing instructions from programs and managing the overall operation of the system. It coordinates the activities of all other hardware components and ensuring that tasks are carried out efficiently. A data storage memory 26 is also coupled to the system bus 20 for access by the host processing unit 22. The data storage memory 26 can store programming and application data needed by the host processor. One or more functional (IP) circuits 28 are further connected to the system bus 20. The functional (IP) circuits can be any intellectual property circuit or block which is used in the system. Examples of such include: a direct memory access (DMA) circuit, a serial peripheral interface (SPI) circuit, a universal asynchronous receiver-transmitter (UART) circuit, a universal serial bus (USB) circuit, a clock and reset generator circuit, a top level register interface circuit, data convertor circuits, etc. A data bridge circuit 36 interconnects the system bus 20 and the memory bus 14 in support of data communications therebetween.

To summarize, the Neural Processing Unit (NPU) is an accelerator designed to enhance the performance of neural processing tasks. Within the system, it communicates with various components, including the system and external memory, to retrieve weights and store sums or partial sums, partial products and/or partial computes. Additionally, it interacts with different sensor functional (IP) circuits and memories to obtain input features.

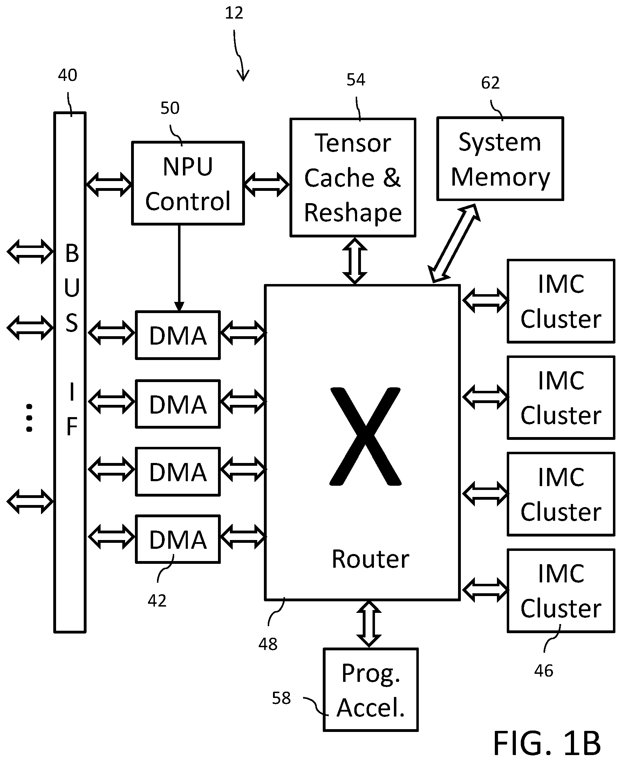

Reference is now made to Figure 1B which shows a block diagram for an individual IMC NPU island 12. Each IMC NPU island 12 includes a bus interface 40 for supporting connection of the island 12 to one or the other or both of the system bus 20 and the memory bus 14. A plurality of direct memory access (DMA) circuits 42 are connected to the bus interface 40. The DMA circuits 42 function as data movers, and operate to move data from one memory to another memory. In this case, the DMA circuits 42 are used to transfer the data from External Flash/Non-Volatile Memory to System memory or System memory to IMC memory and IMC Outputs to System Memory. A plurality of IMC tile clusters 46 are interconnected to the DMA circuits 42 through a local router circuit 48. A control circuit 50 for NPU operations is connected to the bus interface 40 and to the DMA circuits 42. The NPU control circuit 50 controls the different modules of the NPU subsystem. All the NPU programming registers are part of the NPU control. A tensor cache and reshaping circuit 54 is coupled to the local router circuit 48. The tensor cache and reshaping module 54 functions to reshape the input features and weights as required by the IMC tiles for computation. A program accelerator circuit 58 is coupled to the local router circuit 48 and is configured to perform various scalar operations within the NPU. A system non-volatile memory circuit 62 is also coupled to the local router circuit 48. This memory circuit 62 is configured to store weight data for the in-memory computation operations, with this weight data being selectively accessed and delivered through the local router circuit 48 to the IMC tile clusters 46.

To summarize, the IMC NPU island 12 comprises a collection of (for example, one or more) IMC tile clusters 46. This IMC NPU island 12 features a control circuit 50 that manages the NPU, a data reshaping block 54 to adjust input data for the IMC clusters, data movers 42 to facilitate data transfer, and accelerators 58 to perform various scalar operations within the NPU. All these different blocks coordinate and communicate with each other via the local router circuit 48. Data communications to and from the IMC NPU island are handled by a bus interface 40.

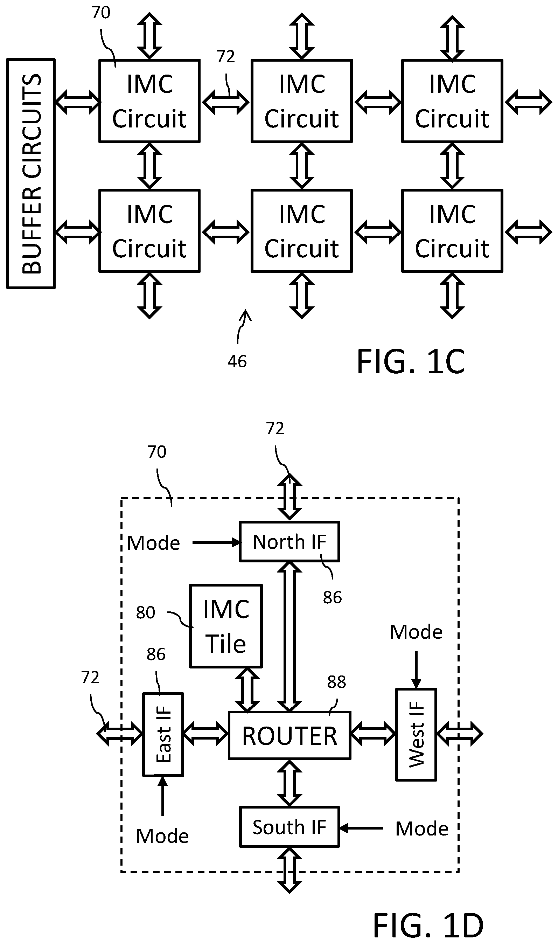

Reference is now made to Figure 1C which shows a block diagram of an IMC tile cluster 46. Each tile cluster 46 includes a plurality of IMC circuits 70 arranged in an array. Adjacent circuits 70 are interconnected for data communication over a shared resource bus 72. The tile cluster 46 is connected to the router 48 of the IMC NPU island 12. The arrangement of the IMC circuits 70 can be programmed depending on processing requirement so that a certain IMC circuit 70 is connected to the router 48 of the IMC NPU island 12. The connection between the tile cluster 46 and the router 48 is facilitated through a set of buffer circuits (Figure 1C shows an example) which are part of the tile cluster 46. The shared resource bus 72 may be used by the IMC circuits 70 for the purpose of communicating, from one circuit 70 to an adjacent circuit 70, feature data, weight data and/or computation data.

An advantage of using a shared resource bus 72 is that separate buses or communications links need not be provided to carry different types of data (such as feature data, weight data and/or computation data). There is also support for shared compute resources between two or more IMC circuits 70. This also facilitates having certain IMC circuits 70 within a given tile cluster 46 be configured to have certain computation logic and/or decompressor logic that is shared for use, in a time-shared manner, by all IMC circuits 70 within the tile cluster 46. The decompressor logic within the certain IMC circuit 70 can be used to process compressed computation weights stored the processing tile memory to access and output decompressed weight data to other IMC circuits 70 within the tile cluster 46. The presence of structured and unstructured sparsity in both weight data and feature data gives the opportunity of compressing the data and using the processing tiles of the IMC circuits 70 in a dense manner. The inclusion of decompressor logic can be costly, and thus providing a solution where decompressor logic is shared across tiles presents a significant advantage.

The IMC tile cluster 46 thus comprises one or more IMC circuits 70. Within a cluster, these IMC circuits 70 can be utilized independently or linked in various configurations to handle any neural network workload.

Figure 1D shows a block diagram of an embodiment for the IMC circuit 70. Each IMC circuit 70 includes an IMC processing tile 80. The tile 80 may be configured for performing a digital in-memory computation operation (DIMC) based on stored weight data and received feature data. An example of such a DIMC processing tile is shown in United States Patent Application Publication No. 2024/0071439 (incorporated herein by reference). This DIMC processing tile may, as noted above, include computation logic which provides a processing resource that can be shared by the processing tiles 80 of other IMC circuits 70. This DIMC processing tile may, as noted above, also include decompressor logic which provides a further processing resource relating to decompressing stored weight data that can be shared by the processing tiles 80 of other IMC circuits 70. Alternatively, the tile 80 may be configured for performing an analog in-memory computation operation (AIMC) based on stored weight data and received feature data. An example of such an AIMC processing tile is shown in United States Patent Application Publication No. 2024/0112728 (incorporated herein by reference). This AIMC processing tile may, as noted above, include a data converter computation resource which can be shared by the processing tiles 80 of other IMC circuits 70.

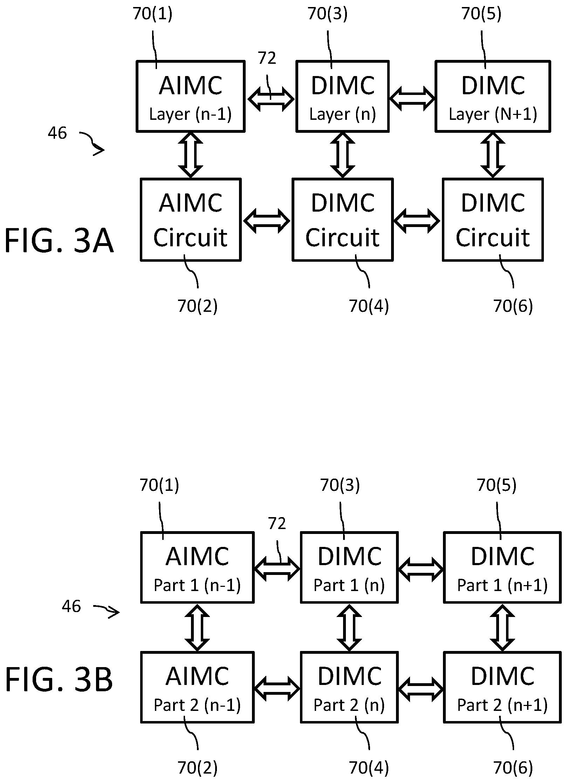

A given tile cluster 46 may include one or more IMC circuits 70 which utilize a DIMC processing tile 80, and one or more IMC circuits 70 which utilize an AIMC processing tile 80. Indeed, there may exist certain configurations for a tile cluster 46 where an IMC circuit 70 using a DIMC processing tile 80 is coupled (for example, positioned adjacent) to an IMC circuit 70 using an AIMC processing tile 80, and the shared resource bus 72 interconnects those DIMC/AIMC processing tiles 80 for data communication. Examples of neural network graph schedules implicating use of both DIMC processing tiles and AIMC processing tiles are shown in Figures 3A-3C discussed in more detail below.

Each IMC circuit 70 is coupled to the shared resource bus 72 through an interface circuit (IF) 86 for engaging in data communications with an adjacent IMC circuit 70 (through its corresponding interface circuit 86). In the example arrayed configuration of the tile cluster 46, there is an interface circuit 86 associated with each Cardinal compass direction (north, south, east, west). The processing tile 80, analog or digital as the case may be, for that IMC circuit 70 is coupled for data communication to a given one of the interface circuits 86 through a router circuit 88. In an example embodiment, the router circuit 88 may be implemented using a packet switched network or a circuit switched network.

Each IMC processing tile 80 (whether analog or digital) is coupled to the router circuit 88 to receive feature data of the in-memory computation operation being performed. That feature data may, for example, be communicated to the IMC processing tile 80 via the router 48 of the IMC NPU island 12 over the shared resource buses 72 which interconnect IMC processing tiles 80 and the router 88. Each IMC processing tile 80 (whether analog or digital) is also coupled to the router circuit 88 to receive weight data of the in-memory computation operation being performed. That weight data may, for example, be communicated to the IMC processing tile 80 via the router 48 of the IMC NPU island 12 (for example, being retrieved from the ePCM memory 62) over the shared resource buses 72 which interconnect IMC processing tiles 80 and the router 88. Additionally, each IMC processing tile 80 (whether analog or digital) is coupled to the router circuit 88 to output processing data (for example, partial sum, partial product and/or partial compute outputs) of the in-memory computation operation being performed. That processing data may, for example, be communication from the IMC processing tile 80 over the shared resource buses 72 which interconnect IMC processing tiles 80 and the router 88.

Each interface circuit 86 receives a mode control signal (Mode) that specifies an operational mode of the shared resource bus 72 connected to the interface circuit 86. In a first mode selected in response to a first signal state of the Mode control signal, all of the signal lines of the shared resource bus 72 are utilized for data communications between adjacent IMC circuit 70 (for example, using digital signaling of a selected type). In a second mode selected in response to a second signal state of the Mode control signal, a first subset of the signal lines of the shared resource bus 72 are utilized for data communications between adjacent IMC circuits 70 (for example, using digital signaling or analog signaling of a selected type) and a second subset of the signal lines of the shared resource bus 72 are set to a fixed voltage level. In an embodiment, the fixed voltage level is a reference voltage level such as a ground voltage. In an embodiment, the first subset comprises one-half of the signal lines of the shared resource bus 72 and the second subset comprises one-half of the signal lines of the shared resource bus 72. For example, for a shared resource bus 72 having N signal lines in parallel, the first subset includes N/2 signal lines and the second subset includes N/2 signal lines. In an embodiment, the signal lines in the first subset are interleaved with the signal lines in the second subset. For example, for a shared resource bus 72 having N signal lines in parallel, the first subset includes the even number signal lines (numbered 0, 2, 4, ..., N-2) and the second subset includes the odd number signal lines (numbered 1, 3, 5, ..., N-1). Where the Mode control signal is in the second signal state, and the second mode has been selected, the signal lines of the shared resource bus 72 in the second subset which are at the fixed (reference, ground) voltage level function as shielding lines for the signal lines of the shared resource bus 72 in the first subset which are configured to transmit data between adjacent IMC circuits 70. This shielding serves to ensure a clean signal connection between the adjacent IMC circuits 70 over the shared resource bus 72.

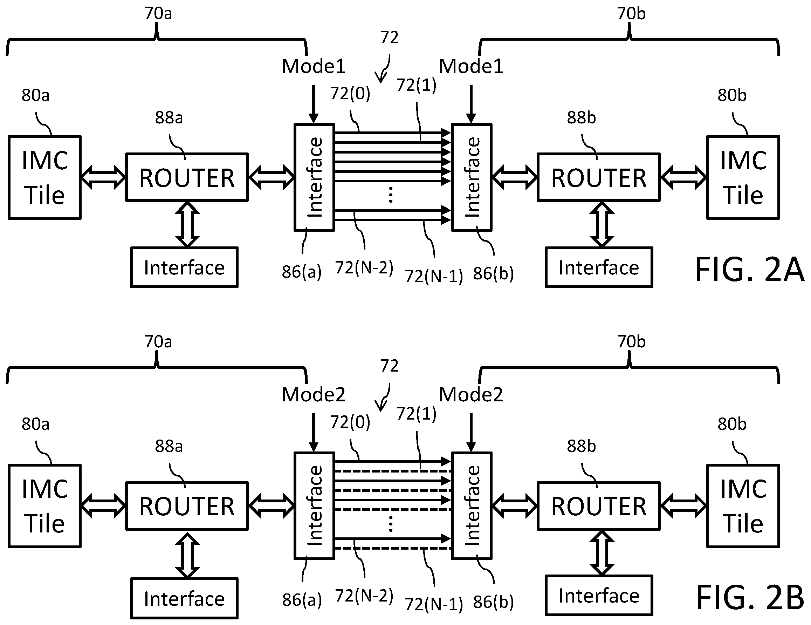

Reference is now made to Figures 2A and 2B which illustrates a simplified example for the first and second mode, respectively. A first IMC circuit 70a includes a first IMC processing tile 80a coupled through a first router circuit 88a to at least a first interface circuit 86a (in one of the Cardinal directions, a further interface circuit for another Cardinal direction being shown by example). The first interface circuit 86a includes transceiver (TX/RX) drive circuits coupled to the N signal lines 72(0) to 72(N-1) of the shared resource bus 72. A second IMC circuit 70b includes a second IMC processing tile 80b coupled through a second router circuit 88b to a second interface circuit 86b (in a complementary Cardinal direction, a further interface circuit for another Cardinal direction being shown by example). The second interface circuit 86b includes transceiver (TX/RX) drive circuits coupled to the N signal lines 72(0) to 72(N-1) of the shared resource bus 72. Each of the interface circuits 86a, 86b receives a Mode control signal.

With respect to Figure 2A, in response to a first signal state of the Mode control signal (Model) selecting the first mode, all of the TX/RX drive circuits coupled to the N signal lines 72(0) to 72(N-1) of the shared resource bus 72 are enabled to support data communication over the shared resource bus 72 between the first and second IMC circuits 70a, 70b (as indicated by the arrow lines). For example, the TX drive circuits in the first interface circuit 86a and the RX drive circuits in the second interface circuit 86b are enabled for data communication. In this first mode, for example, the TX drive circuits of the first IMC circuit 70a may send feature data for the in-memory computation operation from the first IMC processing tile 80a over the N signal lines 72(0) to 72(N-1) of the shared resource bus 72 to the RX drive circuits of the second IMC circuit 70b for use by the second IMC processing tile 80b, or may send weight data for the in-memory computation operation from the first IMC processing tile 80a over the N signal lines 72(0) to 72(N-1) of the shared resource bus 72 to the second IMC circuit 70b for use by the second IMC processing tile 80b, or may send computation data (such as a partial sum, partial product and/or partial compute) calculated by the first IMC processing tile 80a over the N signal lines 72(0) to 72(N-1) of the shared resource bus 72 to the second IMC circuit 70b for use by the second IMC processing tile 80b.

As the shared resource bus 72 is bidirectional, it will be understood (notwithstanding the arrow indication in Figure 2A) that communication of data (feature, weight, computation) may instead flow in the opposite direction over the N signal lines 72(0) to 72(N-1) of the shared resource bus 72 from the second IMC circuit 70b to the first IMC circuit 70a. This is accomplished by instead configuring the TX/RX drive circuits of the first interface circuit 86a to operate in receive mode while the TX/RX drive circuits of the second interface circuit 86b operate in transmit mode.

Reference is now made to Figure 2B. In response to a second signal state of the Mode control signal (Mode2) selecting the second mode, the TX/RX drive circuits of the first and second interface circuits 86a, 86b coupled to a first subset of the signal lines of the shared resource bus 72 are enabled to support data communications between the first and second IMC circuits 70a, 70b (as indicated by the arrow lines). However, the second signal state of the Mode control signal will also cause the TX/RX drive circuits of the first and second interface circuits 86a, 86b coupled to a second subset of the signal lines of the shared resource bus 72, different from the first subset, to drive the second subset of the signal lines to a fixed voltage level such as a reference or ground voltage level (as indicated by the dashed lines). In this second mode, for example, the TX drive circuits of the first IMC circuit 70a may send feature data for the in-memory computation operation from the first IMC processing tile 80a over the first subset of signal lines (for example, even numbered lines 72(0), 72(2), 72(4), ..., 72(N-2)) of the shared resource bus 72 to the RX drive circuits of the second IMC circuit 70b for use by the second IMC processing tile 80b, or may send weight data for the in-memory computation operation from the first IMC processing tile 80a over the first subset of signal lines of the shared resource bus 72 to the second IMC circuit 70b for use by the second IMC processing tile 80b, or may send computation data (such as a partial sum, partial product and/or partial compute) calculated by the first IMC processing tile 80a over the first subset of signal lines of the shared resource bus 72 to the second IMC circuit 70b for use by the second IMC processing tile 80b. While in the second mode, the second subset of signal lines (for example, odd numbered lines 72(1), 72(3), 72(5), ..., 72(N-1)) of the shared resource bus 72 are held at the fixed (reference or ground) voltage level by the TX/RX drive circuits of the first and second interface circuits 86a, 86b to function as shielding lines.

As the shared resource bus 72 is bidirectional, it will be understood (notwithstanding the arrow indication in Figure 2B) that communication of data (feature, weight, computation) may instead flow in the opposite direction over the first subset of signal lines of the shared resource bus 72 from the second IMC circuit 70b to the first IMC circuit 70a. This is accomplished by instead configuring the TX/RX drive circuits of the first interface circuit 86a coupled to the first subset of the signal lines to operate in receive mode while the TX/RX drive circuits of the second interface circuit 86b coupled to the first subset of the signal lines operate in transmit mode.

Reference is now made to Figures 3A-3C which illustrate neural network graph schedules where an IMC tile cluster makes use of both analog and digital IMC processing tile resources.

In Figure 3A, the tile cluster 46 includes a plurality of IMC circuits 70, where IMC circuits 70(1) and 70(2) each utilize an AIMC processing tile 80 and where IMC circuits 70(3), 70(4), 70(5) and 70(6) each utilize which utilize a DIMC processing tile 80. The neural network graph schedule for Figure 3A shows an example of a layer pipeline (which comprises a mapping of different layers of a given neural network onto different IMC tiles; this mapping being managed by the compiler). The layer pipeline includes a layer (n-1) which utilizes the IMC circuit 70(1) and its AIMC processing tile 80, a layer (n) which utilizes the IMC circuit 70(3) and its DIMC processing tile 80, and a layer (n+1) which utilizes the IMC circuit 70(5) and its DIMC processing tile 80. For the processing scenario where the output of layer (n-1) is provided as input to layer (n), there would be a communications interconnection in mode 2 (Figure 2B) over the shared resource bus 72 between the IMC circuits 70(1) and 70(3). For the processing scenario where the output of layer (n) is provided as input to layer (n+1), there would be a communications interconnection in mode 1 (Figure 2A) over the shared resource bus 72 between the IMC circuits 70(3) and 70(5). The IMC circuits 70(2), 70(4) and 70(6) do not participate in this processing pipeline, but may be operating in parallel with respect to a different processing pipeline.

In Figure 3B, the tile cluster 46 includes a plurality of IMC circuits 70, where IMC circuits 70(1) and 70(2) each utilize an AIMC processing tile 80 and where IMC circuits 70(3), 70(4), 70(5) and 70(6) each utilize which utilize a DIMC processing tile 80. The neural network graph schedule for Figure 3B shows an example of a tensor pipeline (which is implemented in scenarios where a full unrolled tensor is not fully mappable in one tile, and is instead pipelined across multiple tiles; again this being managed by the compiler). The tensor pipeline includes a layer (n-1) which utilizes IMC circuit 70(1) and its AIMC processing tile 80 for part 1 of the tensor operation and IMC circuit 70(2) and its AIMC processing tile 80 for part 2 of the tensor operation, a layer (n) which utilizes IMC circuit 70(3) and its DIMC processing tile 80 for part 1 of the tensor operation and IMC circuit 70(4) and its DIMC processing tile 80 for part 2 of the tensor operation, and a layer (n+1) which utilizes IMC circuit 70(5) and its DIMC processing tile 80 for part 1 of the tensor operation and IMC circuit 70(6) and its DIMC processing tile 80 for part 2 of the tensor operation. For the processing scenario where the output of layer (n-1) is provided as input to layer (n), there would be a communications interconnection in mode 2 (Figure 2B) over plural shared resource buses 72 between the IMC circuits 70(1) and 70(3) for part 1 of the tensor operation and between the IMC circuits 70(2) and 70(4) for part 2 of the tensor operation. For the processing scenario where the output of layer (n) is provided as input to layer (n+1), there would be a communications interconnection in mode 1 (Figure 2A) over plural shared resource buses 72 between the IMC circuits 70(3) and 70(5) for part 1 of the tensor operation and between the IMC circuits 70(4) and 70(6) for part 2 of the tensor operation.

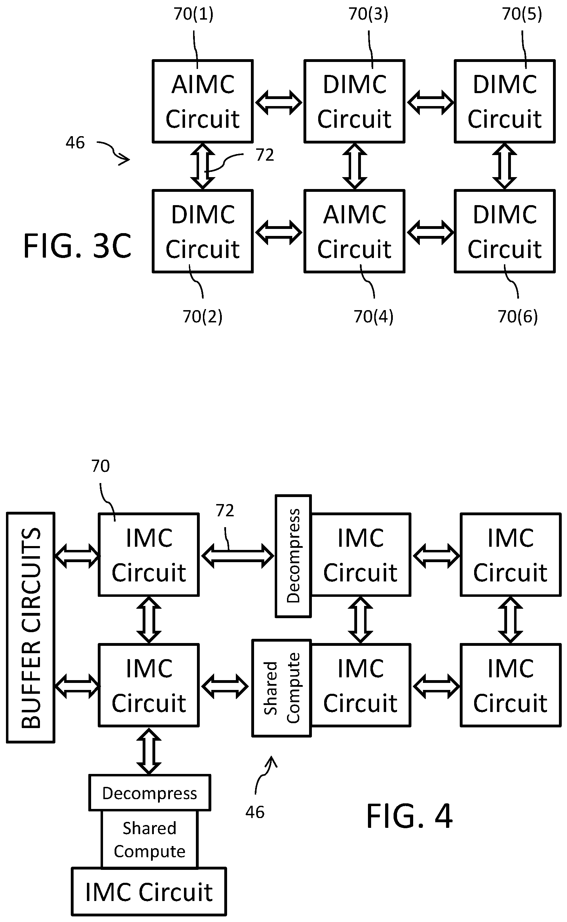

In Figure 3C, the tile cluster 46 includes a plurality of IMC circuits 70, where IMC circuits 70(1) and 70(4) each utilize an AIMC processing tile 80 and where IMC circuits 70(2), 70(3), 70(5) and 70(6) each utilize which utilize a DIMC processing tile 80. The neural network graph schedule for Figure 3C shows an example of a multi-modal network implementation where a first modality uses IMC circuits 70(1) and 70(2) in a processing pipeline, a second modality uses IMC circuits 70(3) and 70(4) in a processing pipeline, and a third modality uses IMC circuits 70(5) and 70(6) in a processing pipeline. For the first modality where the output of AIMC circuit 70(1) is provided as input to DIMC circuit 70(2), there would be a communications interconnection in mode 2 (Figure 2B) over the shared resource bus 72 between the IMC circuits 70(1) and 70(3). For the second modality where the output of DIMC circuit 70(3) is provided as input to AIMC circuit 70(4), there would be a communications interconnection in mode 1 (Figure 2A) over the shared resource bus 72 between the IMC circuits 70(3) and 70(4). Likewise, for the third modality where the output of DIMC circuit 70(5) is provided as input to DIMC circuit 70(6), there would be a communications interconnection in mode 1 (Figure 2A) over the shared resource bus 72 between the IMC circuits 70(5) and 70(6).

Reference is now made to Figure 4 which shows a configuration of the tile cluster 46 where certain ones of the IMC circuits 70 within the tile cluster 46 include decompressor logic and certain ones of the IMC circuits 70 within the tile cluster 46 include shared compute logic. It will be understood that a given IMC circuit 70 may include both decompressor logic shared compute logic. With IMC circuits 70 having DIMC processing tiles 80, the shared resource bus 72 can be used for communicating weights and partial computation results (for example, partial sum, partial product and/or partial compute) among a plurality of IMC circuits 70, for example having the shared resource bus 72 configured in mode 1 (Figure 2A). The shared compute logic is made available on a time-shared basis to the IMC circuits 70 with the weight and partial computation data being transmitted over the bus 72. Compressed weight data can also be stored in the DIMC processing tile 80 of a given IMC circuit 70, retrieved from the memory for processing in the decompressor logic, and then the decompressed weight data can be delivered over the shared resource bus 72 configured in mode 1 (Figure 2A) for storage in the IMC processing tiles 80 of other IMC circuits 70 in the tile cluster 46. With IMC circuits 70 having AIMC processing tiles 80, the shared resource bus 72 can be configured in mode 2 (Figure 2B) and used for communicating partial computation products generated by a data conversion functionality of the AIMC processing tile. The analog readout from one or more IMC circuits 70 having AIMC processing tiles 80 can be passed over the shared resource bus 72 configured in mode 2 (Figure 2B) for sensing, combination and other processing at the shared computation or processing resource.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention as defined in the appended claims.

## Claims

1. A circuit, comprising:
a first in-memory computation (IMC) circuit comprising a first IMC processing tile coupled for data communication to a first interface circuit;
a second IMC circuit comprising a second IMC processing tile coupled for data communication to a second interface circuit;
a shared resource bus connecting the first interface circuit to the second interface circuit;
wherein the first and second interface circuits are controlled by mode control signals to operate in:
a first communications mode where signal lines of the shared resource bus support data communications between the first and second IMC circuits; and
a second communications mode where a first subset of signal lines of the shared resource bus support data communications between the first and second IMC circuits and a second subset of signal lines of the shared resource bus, different from the first subset, are driven to a fixed voltage level to provide shielding for the data communications over the first subset of signal lines.

2. The circuit of claim 1, wherein the data communications between the first and second IMC circuits in either the first communications mode or the second communications mode comprise feature data for in-memory computation operations performed by one or more of the first and second IMC processing tiles.

3. The circuit of claim 1, wherein the data communications between the first and second IMC circuits in either the first communications mode or the second communications mode comprise weight data for in-memory computation operations performed by one or more of the first and second IMC processing tiles.

4. The circuit of claim 1, wherein the data communications between the first and second IMC circuits in either the first communications mode or the second communications mode comprise processing data generated by execution of an in-memory computation operation by one of the first and second IMC processing tiles.

5. The circuit of claim 1, wherein the first IMC processing tile includes a decompressor logic, and wherein a memory of the first IMC processing tile stores compressed weight data for in-memory computation operations, and wherein the decompressor logic is configured to decompress the compressed weight data to generate decompressed weight data which is communicated from the first IMC processing tile to the second IMC processing tile over the shared resource bus.

6. The circuit of claim 1, wherein the first IMC processing tile includes a shared compute logic; and the shared compute logic receives data over the shared resource bus from the second IMC processing tile and performs computation operations on the received data.

7. The circuit of claim 1, wherein the first IMC processing tile includes a shared compute logic; and the shared compute logic performs computation operations to generate computation data communicated from the first IMC processing tile to the second IMC processing tile over the shared resource bus.

8. The circuit of claim 1, wherein the first and second IMC circuits are layers in a layered pipeline processing operation.

9. The circuit of claim 1, wherein the first and second IMC circuits are parts of layers in a tensor pipeline processing operation.

10. The circuit of claim 1, wherein the first and second IMC circuits are parts of processing modality.

11. A circuit, comprising:
a first in-memory computation (IMC) tile coupled to a first data communication interface circuit;
a second IMC tile coupled to a second data communication interface circuit;
a shared resource bus connecting the first data communication interface circuit to the second data communication interface circuit;
wherein a data communication mode implemented by the first and second interface circuits for data communication between the first and second IMC tiles is controlled by a mode control signal such that:
when the mode control signal indicates operation in a first data communications mode, all signal lines of the shared resource bus support data communications between the first and second IMC tiles; and
when the mode control signal indicates operation in a second data communications mode, a first subset of signal lines of the shared resource bus support data communications between the first and second IMC tiles and a second subset of signal lines of the shared resource bus, different from the first subset, provide shielding for the data communications over the first subset of signal lines.

12. The circuit of claim 11, wherein the first and second data communication interface circuits drive the second subset of signal lines of the shared resource bus to a reference voltage level when in the second data communications mode.

13. The circuit of claim 11, wherein the data communications between the first and second IMC tile in either the first communications mode or the second communications mode comprise communication of feature data for use in in-memory computation operations performed by one or more of the first and second IMC tiles.

14. The circuit of claim 11, wherein the data communications between the first and second IMC circuits in either the first communications mode or the second communications mode comprise communication of weight data for use in in-memory computation operations performed by one or more of the first and second IMC tiles.

15. The circuit of claim 11, wherein the data communications between the first and second IMC circuits in either the first communications mode or the second communications mode comprise communication of processing data generated by execution of an in-memory computation operation by one of the first and second IMC processing tiles.
